# EUROPÄISCHE PATENTANMELDUNG

(11) **EP 2 910 902 A1**
(43) Veröffentlichungstag der Anmeldung: **26.08.2015**
(21) Anmeldenummer: 15155815.2
(22) Anmeldetag: 19.02.2015
(51) Int. Cl.: G01D 4/00

(54) **Vorrichtung und Verfahren zur Erfassung des Energieverbrauchs in einem lokalen Stromversorgungssystem**

(30) Priorität: 21.02.2014 DE 102014102264
(71) Anmelder: LOKISA Smart Energy GmbH, 53894 Mechernich (DE)
(72) Erfinder: Salewski, Christian, 53894 Mechernich (DE)
(74) Vertreter: Loock, Jan Pieter

(57) **Zusammenfassung**

Es wird eine Vorrichtung (1) zur Erfassung eines Energieverbrauchs in einem lokalen Stromversorgungssystem (2), welches wenigstens eine Zentralleitung (3) und mehrere von der Zentralleitung abzweigende und mit Verbrauchern (6) verbundene Subleitungen (5) aufweist, vorgeschlagen, wobei die Vorrichtung wenigstens eine Erfassungseinheit (7) zur zentralen Erfassung der individuellen Energieverbräuche der einzelnen Verbraucher aufweist, wobei die Erfassungseinheit wenigstens einen Analog-Digital-Wandler (8) zur Erfassung der elektrischen Spannung auf der Zentralleitung aufweist, wobei ein analoger Eingang des Analog-Digital-Wandlers mit der Zentralleitung verbunden ist, wobei die Erfassungseinheit eine Mehrzahl von Eingangskanälen (10) aufweist, wobei jeder Eingangskanal mit einem in eine der Subleitungen eingebundenen Messwandler (11) zur Messung des Stromflusses durch diese Subleitung gekoppelt ist, wobei die Erfassungseinheit zum sukzessiven Abtasten (20) der Eingangskanäle und zur Bestimmung der individuellen Energieverbräuche in jeder Subleitung in Abhängigkeit des gemessenen Stromflusses durch diese Subleitung und der analog-digital-gewandelten Spannung auf der Zentralleitung konfiguriert ist.

## Beschreibung

### Stand der Technik

Es ist ein ständiges Bestreben der Politik, Gesellschaft und Industrie zur Schonung der Umwelt den Ausstoß von Treibhausgasen zu reduzieren, indem die zur Verfügung stehende Energie effizienter eingesetzt wird. Darüber hinaus sorgen die regelmäßig steigenden Energiepreise dafür, dass die Einsparung von Energie nicht nur aus ökologischen, sondern auch aus ökonomischen Gründen wünschenswert ist. Verschiedene öffentliche Studien haben gezeigt, dass allein durch eine Verhaltensänderung der Verbraucher hin zu einem bewussteren und effizienteren Umgang mit elektrischer Energie 20 bis 30 Prozent des Energieverbrauchs gesenkt werden könnte, ohne dass der Verbraucher hierfür auf elektrische Geräte und somit auf Komfort verzichten müsste.

Um die in ein lokales Stromnetz, beispielsweise eines Privathaushalts, eines kleinen Betriebs oder einer mittelständischen Industrieanlage, eingespeiste elektrische Energie effizienter nutzen zu können, müssen zunächst die individuellen Stromverbräuche der einzelnen in diesem lokalen Stromnetz befindlichen Verbraucher erfasst werden. Erst nachdem die einzelnen Verbraucher und deren Energiebedarf bzw. Bedarfsprofile identifiziert wurden, kann das lokale Stromnetz nebst Verbrauchern optimiert und effizienter gestaltet werden, wie beispielsweise durch Austauschen einzelner Verbraucher oder Veränderung der jeweiligen Einschaltzeiten von einzelnen Verbrauchern relativ zueinander. Auch ein bewussterer Umgang des Verbrauchers mit der elektrischen Energie ist nur dann möglich, wenn der Verbraucher den Energieverbrauch seiner Hauptverbraucher kennt.

Aus dem Stand der Technik ist bekannt, den Energieverbrauch in einem lokalen Stromversorgungssystem mittels eines Stromzählers zentral zu erfassen. Eine solche zentrale Erfassung des Stromverbrauchs ist für die Optimierung des lokalen Stromnetzes samt seiner einzelnen Verbraucher unbrauchbar, da lediglich der Gesamtenergieverbrauch bestimmt wird und keinerlei Informationen über den individuellen Energieverbrauch der einzelnen Verbraucher in diesem Stromnetz gewonnen werden.

Ferner ist bekannt, den Stromverbrauch von einzelnen technischen Geräten mit portablen Stromverbrauchsmessgeräten zu erfassen, welche zwischen den Stecker des Geräts und der Steckdose steckbar sind. Solche Geräte können lediglich einzelne Geräte überwachen und sind daher zur zentralen und professionellen Bestimmung einer dezidierten Energiebilanzübersicht aller in ein lokales Stromversorgungssystem eingebundener Verbraucher nicht geeignet.

### Offenbarung der Erfindung

Es ist eine Aufgabe der vorliegenden Erfindung eine Vorrichtung und ein Verfahren zur Erfassung eines Energieverbrauchs in einem lokalen Stromversorgungssystem, welches wenigstens eine Zentralleitung und mehrere von der Zentralleitung abzweigende und mit Verbrauchern verbundene Subleitungen aufweist, bereitzustellen, welche(s) eine Bestimmung der individuellen Energieverbräuche der einzelnen Verbraucher durch eine zentral angeordnete Erfassungseinheit erlaubt. Zudem sollen die Vorrichtung und das Verfahren möglichst einfach, unauffällig, bauraumkompakt und kostengünstig realisierbar sein.

Gelöst wird diese Aufgabe mit einer Vorrichtung zur Erfassung eines Energieverbrauchs in einem lokalen Stromversorgungssystem, welches wenigstens eine Zentralleitung und mehrere von der Zentralleitung abzweigende und mit Verbrauchern verbundene Subleitungen aufweist, wobei die Vorrichtung wenigstens eine Erfassungseinheit zur zentralen Erfassung der individuellen Energieverbräuche der einzelnen Verbraucher aufweist, wobei die Erfassungseinheit wenigstens einen Analog-Digital-Wandler zur Erfassung der elektrischen Spannung auf der Zentralleitung aufweist, wobei ein analoger Eingang des Analog-Digital-Wandlers mit der Zentralleitung verbunden ist, wobei die Erfassungseinheit eine Mehrzahl von Eingangskanälen aufweist, wobei jeder Eingangskanal mit einem in eine der Subleitungen eingebundenen Messwandler zur Messung des Stromflusses durch diese Subleitung gekoppelt ist, wobei die Erfassungseinheit zum sukzessiven Abtasten der Eingangskanäle und zur Bestimmung der individuellen Energieverbräuche in jeder Subleitung in Abhängigkeit des gemessenen Stromflusses durch diese Subleitung und der analog-digital-gewandelten Spannung auf der Zentralleitung konfiguriert ist.

Die erfindungsgemäße Vorrichtung hat gegenüber dem Stand der Technik den Vorteil, dass die in den einzelnen Subleitungen aufgrund der dort angeschlossenen Verbraucher anfallenden Energieverbräuche von einer zentralen Erfassungseinheit individuell bestimmt werden. Es kann somit eine Verbrauchsübersicht erstellt werden, wie sich die gesamte im Stromversorgungssystem verbrauchte elektrische Energie auf die einzelnen Verbraucher aufteilen. Infolge der genauen Kenntnis dieser Verbrauchsübersicht können gegebenenfalls Gegenmaßnahmen zum Einsparen von elektrischer Energie oder zur effizienteren Nutzung der elektrischen Energie vorgenommen werden oder es können beim Verbraucher Verhaltensänderung herbeigeführt werden, welche zu einem effizienteren Umfang mit elektrischer Energie führen. Denkbar wäre beispielsweise, dass einzelne Verbraucher, deren überdurchschnittlich hoher Energieverbrauch detektiert wurde, mit kürzeren Einschaltzeiten beschaltet werden oder durch energieeffizientere Geräte ersetzt werden. Auch wäre denkbar, solche energieaufwändigen Geräte hauptsächlich zu Nachtzeiten zu betreiben, wenn die Stromkosten geringer ausfallen. Sämtliche solcher Maßnahmen können in Form eines intelligenten Energiemanagements zur Einsparung von Energie und Energiekosten umgesetzt werden, wenn eine dezidierte Übersicht der individuellen Energieverbräuche der Hauptverbraucher im Energieversorgungssystem vorliegen. Die erfindungsgemäße Vorrichtung ist ferner nicht nur zu Erfassung dieser Übersicht geeignet, sondern vorteilhafterweise auch vergleichsweise kostengünstig und bauraumkompakt realisierbar. Dies wird dadurch erreicht, dass die elektrische Spannung, welche im gesamten Stromversorgungssystem gleich sein sollte, zentral abgegriffen und der Erfassungseinheit über den in die Erfassungseinheit integrierten oder separaten Analog-Digital-Wandler zugeführt wird, während in den jeweiligen Subleitungen lediglich der Stromfluss gemessen wird und in Form eines Strommesssignals jeweils auf ein Eingangskanal der Erfassungseinheit gelegt wird. Die Erfassungseinheit weist dabei eine Vielzahl von Eingangskanälen auf, so dass für jede Subleitung ein eigener Eingangskanal vorgesehen ist. Die Eingangskanäle werden sodann von der Erfassungseinheit nacheinander mit einer bestimmten Frequenz abgetastet (auch als "Samplen" bezeichnet) und über den Analog-Digital-Wandler oder einen weiteren Analog-Digital-Wandler ausgelesen, so dass vorteilhafterweise nicht für jeden Messwandler bzw. für jede Subleitung oder Verbraucher ein eigener Analog-Digital-Wandler notwendig ist. Das sukzessive Abtasten der Eingangskanäle ermöglicht hingegen eine Realisierung der erfindungsgemäßen Vorrichtung mit nur einem einzigen Analog-Digital-Wandler. Durch die Kenntnis der zentralen elektrischen Spannung im Stromversorgungssystem können die gesampelten Stromwerte von der Erfassungseinheit sodann in elektrische Energie umgerechnet werden. Die Erfassungseinheit kann somit für jede Subleitung und insbesondere für jeden einer Subleitung zugeordneten Verbraucher den individuellen Energieverbrauch präzise bestimmen. Die Erfassungseinheit umfasst vorzugsweise einen Mikrocontroller, einen Mikroprozessor und/oder einen FPGA (programmierbaren logischen Schaltkreis). Denkbar ist, dass der Analog-Digital-Wandler oder die Analog-Digital-Wandler in den Mikrocontroller, Mikroprozessor und/oder FPGA integriert sind oder ganz oder teilweise als separate Bauteile realisiert sind. Denkbar ist auch, dass Teile der Erfassungseinheit, wie beispielsweise die Eingangskanäle, in einen ASIC (Application Specific Integrated Circuit) implementiert sind. Die Erfassungseinheit ist vorzugsweise im Bereich einer Niederspannungsunterverteilung eines Gebäudes, eines Hausanschlusskastens, eines Hausübergabepunkt oder einer Zähleranschlusssäule angeordnet ist. Dies wird dadurch ermöglicht, dass die Vorrichtung vergleichsweise bauraumkompakt aufgebaut ist. Optional weist die Erfassungseinheit eine Uhr auf, damit für die Verbraucher Energieverbrauchs-Zeitprofile angefertigt werden können.

Vorteilhafte Ausgestaltungen und Weiterbildungen der Erfindung sind den Unteransprüchen, sowie der Beschreibung unter Bezugnahme auf die Zeichnungen entnehmbar.

Gemäß einer bevorzugten Ausführungsform der vorliegenden Erfindung ist vorgesehen, dass die Vorrichtung einen Multiplexer aufweist, welcher beim sukzessiven Abtasten der Eingangskanäle die Eingangskanäle nacheinander auf den analogen Eingang des Analog-Digital-Wandlers oder auf einen analogen Eingang eines weiteren Analog-Digital-Wandlers schaltet. In vorteilhafter Weise kann somit eine große Anzahl von Subleitungen mit nur einem Analog-Digital-Wandler überwacht werden. Denkbar ist auch, dass die Außenleiter der Zentralleiter, typischerweise ein Außenleiter oder drei Außenleiter, ebenfalls auf den Analog-Digital-Wandler gesampelt werden, so dass auch die elektrische Spannung auf der Zentralleitung von dem einen Analog-Digital-Wandler gewandelt wird.

Gemäß einer bevorzugten Ausführungsform der vorliegenden Erfindung ist vorgesehen, dass die Messwandler jeweils einen Stromwandler, insbesondere in Form einer Durchsteckspule, durch welche jeweils die zugehörige Subleitung verläuft, umfassen. Der Messwandler ist über Signalleitungen mit einem bekannten Messwiderstand verbunden, über welche dann eine Spannung abfällt, welche dem Stromfluss durch die Subleitung proportional ist. Das resultierende Strommesssignal wird auf den jeweiligen Eingangskanal gelegt und beim Abtasten vom Analog-Digital-Wandler in einen Digitalwert gewandelt. Die Multiplikation des Strommesswertes mit der zentralen Spannung ergibt sodann die elektrische Energie, welche in der Subleitung aktuell verbraucht wird. Denkbar ist, dass die jeweiligen Messwiderstände im Bereich der Erfassungseinheit und insbesondere in der Nähe der Eingangskanäle und nicht im Bereich der Subleitungen angeordnet sind. Alternativ wäre aber auch denkbar, die Messwiderstände unmittelbar im Bereich der Messwandler anzuordnen.

Gemäß einer bevorzugten Ausführungsform der vorliegenden Erfindung ist vorgesehen, dass die Messwandler jeweils über separate Signalleitungen direkt mit den Messwiderständen und/oder indirekt mit den Eingangskanälen fest verdrahtet sind. In vorteilhafter Weise ist somit eine kostengünstige und ausfallsichere Kopplung zwischen jedem Messwandler und dem jeweiligen zugehörigen Eingangskanal zur Übertragung der Strommesswerte möglich. Die Signalübermittelung von den Messwandlern zur Erfassungseinheit erfolgt hierbei drahtgebunden. Alternativ ist vorgesehen, dass die Messwandler jeweils über eine drahtlose Funkverbindung mit direkt den Messwiderständen und/oder indirekt mit den Eingangskanälen gekoppelt sind. Die Signalübermittelung von den Messwandlern zur Erfassungseinheit erfolgt somit drahtlos. Vorteilhafterweise kann eine solche Vorrichtung vergleichsweise leicht, schnell und kostengünstig in bestehende Stromversorgungssysteme nachgerüstet werden, da für die Übermittelung der Strommessdaten keine zusätzlichen Leitungen verlegt werden müssen.

Gemäß einer weiteren bevorzugten Ausführungsform der vorliegenden Erfindung ist vorgesehen, dass die Messwandler nur über die jeweilige Subleitung mit der Erfassungseinheit fest gekoppelt sind, wobei der Messwandler einen Modulator zum Modulieren der gemessenen Messdaten auf die Subleitung aufweist und wobei die Vorrichtung einen mit den Eingangskanälen der Erfassungseinheit verbundenen Demodulator zum Demodulieren der auf die Subleitung modulierten Messdaten aufweist. In vorteilhafter Weise ist hierbei weder eine Funkverbindung, noch die Installation zusätzlicher Leitungen zur Übermittelung der Strommessdaten von den Messwandlern an die Eingangskanäle der Erfassungseinheit notwendig, da die Strommessdaten über die ohnehin bestehenden und zur Zentralleitung führenden Subleitungen übertragen werden.

Gemäß einer weiteren bevorzugten Ausführungsform der vorliegenden Erfindung ist vorgesehen, dass die Erfassungseinheit derart konfiguriert ist, dass in Abhängigkeit der auf der Zentralleitung erfassten zeitabhängigen elektrischen Spannung und des in der jeweiligen Subleitung erfassten zeitabhängigen elektrischen Stroms für jede Subleitung die Phasenbeziehung zwischen Spannung und Strom bestimmt und daraus die in der betreffenden Subleitung anfallende Wirkleistung ermittelt wird. In vorteilhafter Weise kann anhand der Änderung der elektrische Spannung und der Änderung des elektrischen Stromes in der Subleitung die Phasenbeziehung der elektrischen Spannung und des elektrischen Stromes berücksichtigt werden, beispielsweise durch Bestimmung des jeweiligen Nulldurchgangs, damit in jeder Subleitung nicht nur die Scheinleistung, sondern auch die tatsächlich anfallende Wirkleistung berechnet werden kann. Dies ist insbesondere für Privathaushalte wichtig, die Verbraucher mit einer frequenzabhängigen Phasenverschiebung und Widerstandsänderung aufweisen, da Privathaushalte lediglich die tatsächlich angefallene Wirkleistung müssen.

Gemäß einer weiteren bevorzugten Ausführungsform der vorliegenden Erfindung ist vorgesehen, dass die Vorrichtung eine mit der Erfassungseinheit verbundene Auswerteeinheit zur Auswertung der individuellen Energieverbräuche der einzelnen Verbraucher aufweist, wobei die Auswerteeinheit vorzugsweise eine Benutzerschnittstelle, insbesondere eine Bedienkonsole, und/oder eine Maschinenschnittstelle, insbesondere eine Webschnittstelle, aufweist. Die Auswerteeinheit weist ferner vorzugsweise eine Uhr und einen Speicher zum Erstellen und Speichern von Zeitprofilen der Energieverbräuche auf. Vorteilhafterweise können die Energieverbräuche und die Zeitprofile der Energieverbräuche unmittelbar über die Benutzerschnittstelle angezeigt und somit von einem Benutzer analysiert werden. Die Benutzerschnittstelle umfasst hierfür beispielsweise eine Anzeigevorrichtung und Eingabeeinheit, wie ein Display und eine Eingabeeinheit oder ein Touchscreen oder dergleichen. Alternativ oder zusätzlich weist die Vorrichtung eine Maschinenschnittstelle auf, so dass die erfassten Energieverbräuche und Zeitprofile von einer Auswerteeinheit beispielsweise in Form eines Computers, eines Tablet-PCs, eines Smartphones automatisch oder manuell ausgelesen werden können. Denkbar ist, dass die Auswerteeinheit drahtgebunden, beispielsweise über ein LAN-Kabel, ein USB-Kabel oder dergleichen, oder drahtlos, beispielsweise über WLAN, Bluetooth oder IR, mit der Erfassungseinheit verbunden ist. Ferner ist denkbar, dass die Auswerteeinheit eine Webschnittstelle aufweist, so dass die erfassten Energieverbräuche und Zeitprofile über das Hypertext Transfer Protocol (HTTP) abgerufen werden können.

Gemäß einer weiteren bevorzugten Ausführungsform der vorliegenden Erfindung ist vorgesehen, dass die Auswerteeinheit eine Steuerungseinheit aufweist, welche zur Steuerung von Verbrauchern im lokalen Stromversorgungssystem vorgesehen ist. Die Steuerungseinheit dient dazu den Energieverbrauch im lokalen Stromversorgungssystem automatisch zu steuern, um den Energieverbrauch zu optimieren. Denkbar ist, dass die Steuerungseinheit nicht nur über die Erfassungseinheit mit Energieverbrauchern, sondern auch mit Energiequellen, wie beispielsweise einer Photovoltaikanlage, einer Windanlage, einem kraftstoffbetriebenen Stromgenerator oder dergleichen, und/oder mit Energiespeichern, wie beispielsweise Lithium-lonen-Akkus, verbunden ist. Die Auswerteeinheit erfasst sodann nicht nur die zum aktuellen Zeitpunkt oder zu einem regelmäßig wiederkehrenden Zeitpunkt verbrauchte elektrische Energie, sondern auch die gespeicherte elektrische Energie, sowie die aktuelle oder zu bestimmten Zeitpunkten regelmäßig erzeugte elektrische Energie. Zur effizienten Nutzung der Energie werden die Verbraucher, sofern deren Einschaltzeitpunkte variabel sind, nun vorzugsweise derart gesteuert, dass die von den Energiequellen erzeugte elektrische Energie unmittelbar innerhalb des lokalen Stromversorgungssystems verbraucht werden kann oder zur Aufladung der Energiespeicher verwendet werden kann. Ferner wird vermieden, dass energieaufwände Verbraucher eingeschaltet werden, wenn gerade keine elektrische Energie von den Energiequellen erzeugt wird und die Energiespeicher vollständig entladen sind.

Ein weiterer Gegenstand der vorliegenden Erfindung ist ein Verfahren zur Erfassung eines Energieverbrauchs in einem lokalen Stromversorgungssystem, welches wenigstens eine Zentralleitung und mehrere von der Zentralleitung abzweigende und mit Verbrauchern verbundene Subleitungen aufweist, insbesondere mittels einer Vorrichtung gemäß einem der vorhergehenden Ansprüche, mit den Schritten:
- Erfassen der elektrischen Spannung auf der Zentralleitung;
- Wandeln des erfassten Spannungswertes in einen digitalen Spannungswert mittels wenigstens eines Analog-Digital-Wandlers;
- Erfassen von durch Subleitungen zu den Verbrauchern fließenden Stromflüssen mittels in die Subleitungen jeweils eingebundene Messwandler,
- Übergeben des erfassten Strommesswertes an separate Eingangskanäle einer Erfassungseinheit;
- Sukzessives Abtasten der Eingangskanäle der Erfassungseinheit;
- Bestimmen der individuellen Energieverbräuche in jeder Subleitung in Abhängigkeit des abgetasteten Strommesswertes für diese Subleitung und der analog-digital-gewandelten Spannung auf der Zentralleitung.

Das erfindungsgemäße Verfahren ermöglicht gegenüber dem Stand der Technik eine individuelle Bestimmung der in den Subleitungen aufgrund der dort angeschlossenen Verbraucher anfallenden Energieverbräuche von einer zentralen Erfassungseinheit, ohne dass für jede Subleitung ein vergleichsweise großer und kostenintensiver Analog-Digital-Wandler benötigt wird. Vorzugsweise werden dabei mittels einer Auswerteeinheit Zeitprofile der Energieverbräuche der einzelnen Verbraucher erstellt. Die genaue Kenntnis der Energieverbräuche und Zeitprofile ermöglich sodann ein intelligentes Energiemanagement zum Ausschöpfen sämtliche Energiesparpotentiale. Denkbar ist, dass die an den Eingangskanälen anliegenden Strommesswerte und optional des Spannungswertes wenigstens eines Außenleiters der Zentralleitung (Alternativ: Drei Außenleiter bei Drehstrom) mittels eines Multiplexer sukzessive auf einen analogen Eingang des Analog-Digital-Wandlers geschaltet werden.

Gemäß einer weiteren bevorzugten Ausführungsform der vorliegenden Erfindung ist vorgesehen, dass die Strommesswerte mittels Messwandlern in Form von Stromwandlern und insbesondere Durchsteckspulen erfasst und mittels Messwiderständen in Strommesswerte umgewandelt werden. Vorteilhafterweise wird in der Spule eine zum Strom proportionale Spannung induziert (auch als Strommesswert bezeichnet), die über den Messwiderstand (auch als "Shunt" bezeichnet) abfällt, wodurch am bekannten Messwiderstand eine zum Strom in der Subleitung proportionale Spannung abgegriffen werden kann.

Gemäß einer weiteren bevorzugten Ausführungsform der vorliegenden Erfindung ist vorgesehen, dass die von den Messwandlern gemessenen Strommesswerte jeweils über separate Signalleitungen oder über eine drahtlose Funkverbindung indirekt über den Messwiderstand an die Eingangskanäle übermittelt werden. Alternativ ist denkbar, dass die von den Messwandlern gemessenen Strommesswerte auf die Subleitung moduliert werden und an der Erfassungseinheit mit einem Demodulator wieder demoduliert und auf die Eingangskanäle gelegt werden. Auf diese Weise müssen zur Realisierung des erfindungsgemäßen Verfahrens vorteilhafterweise keine neuen Leitungen installiert werden.

Gemäß einer weiteren bevorzugten Ausführungsform der vorliegenden Erfindung ist vorgesehen, dass die einzelnen Verbraucher im lokalen Stromversorgungssystem mittels einer Steuerungseinheit in Abhängigkeit der erfassten Energieverbräuche und insbesondere der Verbrauchsprofile gesteuert werden. Wie bereits ausgeführt wurde, dient die Steuerungseinheit dazu, den Energieverbrauch im lokalen Stromversorgungssystem automatisch zu steuern, um den Energieverbrauch zu optimieren. Denkbar ist, dass die Steuerungseinheit nicht nur aktuellen Energieverbrauchsdaten von den Verbrauchern, sondern auch von Energiequellen und/oder Energiespeichern erhält, um die Verbraucher entsprechend zu steuern.

Weitere Einzelheiten, Merkmale und Vorteile der Erfindung ergeben sich aus den Zeichnungen, sowie aus der nachfolgenden Beschreibung von bevorzugten Ausführungsformen anhand der Zeichnungen. Die Zeichnungen illustrieren dabei lediglich beispielhafte Ausführungsformen der Erfindung, welche den wesentlichen Erfindungsgedanken nicht einschränken.

### Kurze Beschreibung der Zeichnungen

- **Figur 1**: zeigt eine schematische Ansicht einer Vorrichtung und eines Verfahrens gemäß einer beispielhaften ersten Ausführungsform der vorliegenden Erfindung.
- **Figur 2**: zeigt eine schematische Ansicht einer Vorrichtung und eines Verfahrens gemäß einer beispielhaften zweiten Ausführungsform der vorliegenden Erfindung.
- **Figur 3**: zeigt eine schematische Ansicht einer Vorrichtung und eines Verfahrens gemäß einer beispielhaften dritten Ausführungsform der vorliegenden Erfindung.

### Ausführungsformen der Erfindung

In den verschiedenen Figuren sind gleiche Teile stets mit den gleichen Bezugszeichen versehen und werden daher in der Regel auch jeweils nur einmal benannt bzw. erwähnt.

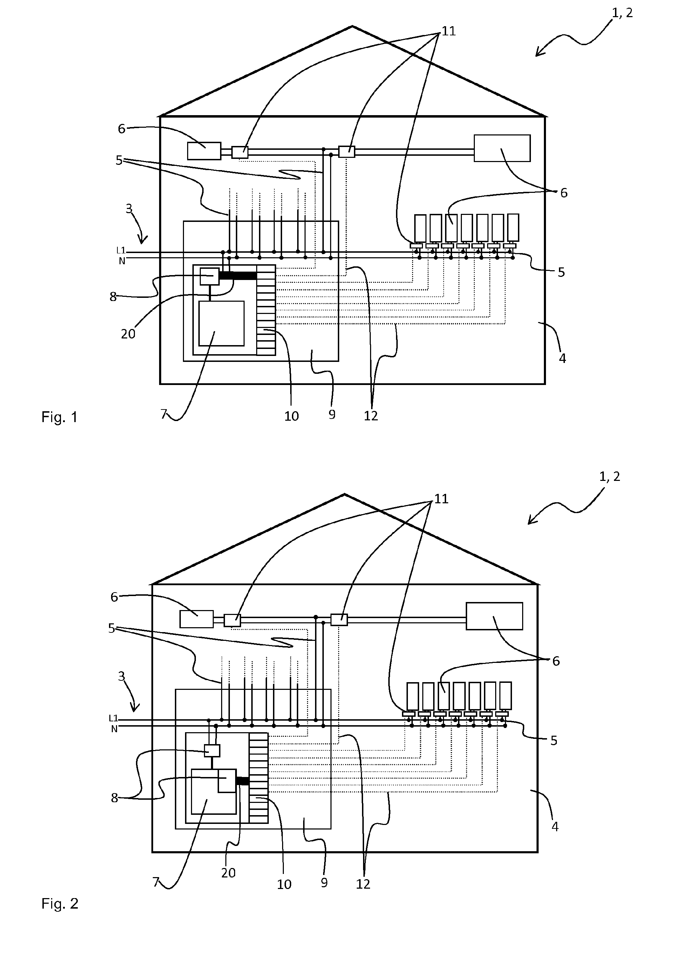

In **Figur 1** ist eine schematische Ansicht einer Vorrichtung 1 und eines Verfahrens gemäß einer beispielhaften ersten Ausführungsform der vorliegenden Erfindung dargestellt. Die Vorrichtung 1 dient zur Erfassung eines Energieverbrauchs in einem lokalen Stromversorgungssystem 2. Das Stromversorgungssystem 2 umfasst im vorliegenden Beispiel das Stromnetz eines Privathaushaltes 4. Das Stromnetz weist eine Zentralleitung 3 auf, welche mit einem Hausübergabepunkt verbunden ist. Von dieser Zentralleitung 3 zweigen in einem zentralen Verteilerkasten 9 eine Mehrzahl von Subleitungen 5 ab, welche beispielsweise in einzelne Räume, in einzelne Etagen, zu einzelnen Verbrauchern 6 bzw. zu einzelnen Steckdosen oder dergleichen führen.

Die Vorrichtung 1 weist eine Erfassungseinheit 7 auf, welche mit wenigstens einem Analog-Digital-Wandler 8 verbunden ist und eine Mehrzahl von Eingangskanälen 10 aufweist. Die Erfassungseinheit 7 weist vorzugsweise einen Mikroprozessor, einen Mikrokontroller oder dergleichen auf. Der Analog-Digital-Wandler 8 ist eingangsseitig über einen Multiplexer 20 mit der Zentralleitung 3 und ausgangsseitig mit der Erfassungseinheit 7 verbunden und dient dazu, die elektrische Spannung auf der Zentralleitung 3 zu messen und als digitalen Spannungswert an die Erfassungseinheit 7 zu übergeben. Der von der Erfassungseinheit 7 auf diese Weise erfasste digitale Spannungswert gilt für das gesamte Stromnetz, da die elektrische Spannung im gesamten Stromversorgungssystem 2 im Wesentlichen konstant ist.

Die Eingangskanäle 10 sind jeweils mit Messwandlern 11 gekoppelt. In jede überwachte Subleitung 5 ist genau ein Messwandler 11 eingebunden, welcher dazu dient, den elektrischen Strom durch die zugehörige Subleitung 5 zu messen. Hierfür weist jeder Messwandler 11 einen Stromwandler in Form einer Durchsteckspule auf, durch welche die Subleitung verläuft. Die Wicklungen der Duchsteckspule sind über Signalleitungen 12 jeweils mit einem im Bereich der Eingangskanäle 10 angeordneten Messwiderstand (Shunt) verbunden. Der Spannungsabfall über den Messwiderstand wird dabei als Strommesswert auf den zugehörigen Eingangskanal 10 gelegt. Die verschiedenen Eingangskanäle 10 sind ebenfalls über den Multiplexer 20 mit dem Analog-Digital-Wandler 8 verbunden und werden von der Erfassungseinheit 7 nacheinander abgetastet bzw. gesampelt, um für jede überwachte Subleitung den zugehörigen Strommesswert abzugreifen. Da der elektrische Widerstand des Messwiderstands bekannt ist, kann innerhalb der Erfassungseinheit 7 der abgetastete Strommesswert in einem zum Stromfluss durch die zugehörige Subleitung 5 proportionalen Stromwert umgerechnet werden. In der Erfassungseinheit 7 wird sodann für jede Subleitung 5 der ermittelte Stromwert mit der an der Zentralleitung 3 zentral erfassten und analog-digital-gewandelten Spannung multipliziert. Auf diese Weise kann mittels der Erfassungseinheit 7 an zentraler Stelle des Stromversorgungssystems 2 der aktuelle Energieverbrauch jedes an einer der Subleitungen 5 hängenden Verbrauchers 6 bestimmt werden. Vorzugsweise werden die Eingangskanäle 10 und die Zentralleitung 3 mit einer vorgegebenen Frequenz abgetastet, so dass nicht nur der aktuelle Momentanverbrauch eines jeden Verbrauchers 6 ermittelt wird, sondern auch der Zeitverlauf von Strom und Spannung in jeder Subleitung bestimmt wird. Aus den Zeitverläufen kann jeweils der Nulldurchgang von Strom und Spannung bestimmt werden, wodurch für jeden Verbraucher 6 auch die Wirkleistung errechnet werden kann. Ferner ist denkbar, dass die Vorrichtung 1 eine Uhr aufweist und somit für jeden Verbraucher 6 ein präzises Zeitprofil des jeweiligen Energieverbrauchs erzeugt werden kann. Vorteilhafterweise benötigt die Vorrichtung 1 nicht für jede Subleitung 5 einen eigenen Analog-Digital-Wandler, so dass die Vorrichtung 1 vergleichsweise bauraumkompakt und energiesparend realisierbar ist. Hierdurch ist insbesondere eine Installation der Erfassungseinheit 7 in den zentralen Verteilerkasten 9 denkbar.

Die Strommessdaten können von den einzelnen Messwandlern 11 über die separaten Signalleitungen 12 oder drahtlos an die Messwiderstände und Eingangskanäle 10 übermittelt werden. Denkbar wäre aber auch, dass die Spannungsmessdaten mittels eines Modulators (nicht dargestellt) auf die jeweilige Subleitung 5 moduliert werden. Im Bereich der Eingangskanäle 10 weist die Vorrichtung 1 dann Demodulatoren auf, welche die auf die Subleitungen 5 modulierten Spannungsmessdaten wieder demodulieren und auf die Eingangskanäle 10 legen. Bei dieser Lösung werden vorteilhafterweise keine separate Signalleitungen 12 benötigt.

Die Erfassungseinheit 7 weist vorzugsweise eine Benutzerschnittstelle, vorzugsweise in Form eine Touchscreens, auf, über welche ein Benutzer die erstellen Energieverbräuche und Zeitprofile analysieren, bearbeiten, exportieren, speichern, vergleichen und dergleichen kann. Alternativ oder zusätzlich weist die Erfassungseinheit eine Maschinenschnittstelle auf, über welche die Daten maschinell abrufbar sind. Denkbar ist, dass die erstellen Energieverbräuche und Zeitprofile beispielsweise mittels einer Webschnittstelle über Hypertext Transfer Protocol (HTTP) abgerufen werden können. Infolge der genauen Kenntnis der Energieverbräuche und Zeitprofile im lokalen Stromversorgungssystem 2 können vom Benutzer gegebenenfalls Gegenmaßnahmen zum Einsparen von elektrischer Energie oder zur effizienteren Nutzung der elektrischen Energie vorgenommen werden. Denkbar wäre beispielsweise, dass einzelne Verbraucher 6, deren überdurchschnittlich hoher Energieverbrauch detektiert wurde, mit kürzeren Einschaltzeiten beschaltet werden oder durch energieeffizientere Geräte ersetzt werden. Auch wäre denkbar, solche energieaufwändigen Geräte hauptsächlich zu Nachtzeiten zu betreiben, wenn die Stromkosten geringer ausfallen.

In **Figur 2** ist eine schematische Ansicht einer Vorrichtung 1 und eines Verfahrens gemäß einer beispielhaften zweiten Ausführungsform der vorliegenden Erfindung dargestellt. Die zweite Ausführungsform gleicht im Wesentlichen der in Figur 1 illustrierten ersten Ausführungsform, wobei bei der zweiten Ausführungsform im Unterschied zur ersten Ausführungsform zwei Analog-Digital-Wandler 8 realisiert sind: Ein von der Erfassungseinheit 7 separater Analog-Digital-Wandler 8, welcher lediglich die elektrische Spannung an der Zentralleitung 3 abtastet und ein weiterer separater Analog-Digital-Wandler 8, auf welchen mittels des Multiplexers 20 die Eingangskanäle 10 gesampelt werden. Optional kann die Funktionalität beider separater Analog-Digital-Wandler 8 auch mit einem einzigen integrierten oder separaten Analog-Digital-Wandler 8 realisiert sein.

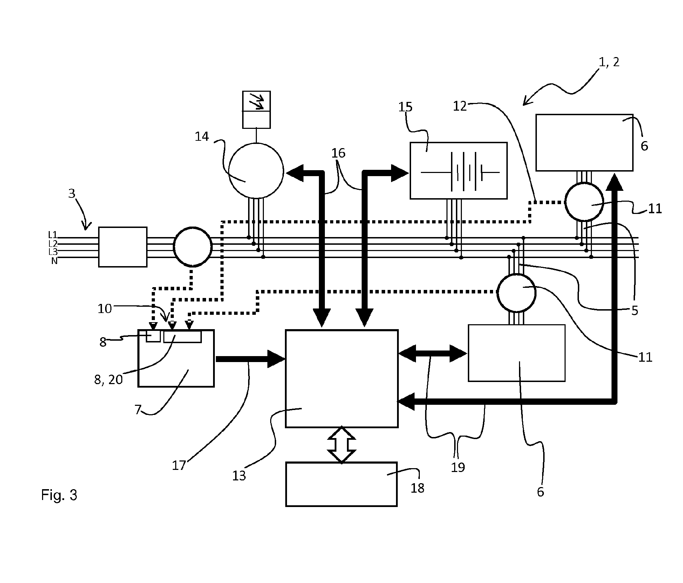

In **Figur 3** ist eine schematische Ansicht einer Vorrichtung 1 und eines Verfahrens gemäß einer beispielhaften dritten Ausführungsform der vorliegenden Erfindung dargestellt. Die dritte Ausführungsform gleicht im Wesentlichen der in Figur 1 illustrierten ersten Ausführungsform, wobei die Vorrichtung 1 gemäß der dritten Ausführungsform zusätzlich eine Auswerteund Steuerungseinheit 13 zur Auswertung der durch die Erfassungseinheit 7 ermittelten Daten und zur Steuerung der Verbraucher 6 in Abhängigkeit der Auswertungsergebnisse aufweist. Zudem ist das lokale Stromversorgungssystem 2 bei der zweiten Ausführungsform im Unterschied zur ersten Ausführungsform beispielhaft als Dreiphasenwechselstromsystem dargestellt. Die drei elektrischen Spannungen auf den drei Außenleitern (L1, L2, L3) der Zentralleitung 3 werden daher zunächst an einem Messpunkt 14 einzeln abgegriffen und sodann von einen Analog-Digital-Wandler 8 jeweils sukzessive abgetastet und an die Erfassungseinheit 7 übergeben. Ferner weisen die Messwandler 11 jeweils drei Durchsteckspuen auf, wobei jeder Außenleiter L1, L2, L3 durch eine Durchsteckspule verläuft. Jede Durchsteckspule ist über Signalleitungen 12 mit einem in der Erfassungseinheit 7 angeordneten Messwiderstand verbunden, wobei der über den jeweiligen Messwiderstands abfallende Strommesswert auf einen Eingangskanal 10 gelegt wird. Mittels eines Multiplexers 20 werden die Strommesswerte von einem in die Erfassungseinheit 7 integrierten Analog-Digital-Wandlers 8 nacheinander abgetastet. Nach dem Abtasten der Strommesswerte unter Berücksichtigung der anliegenden elektrischen Spannung der elektrische Energieverbrauch für die jeweilige Subleitung 5 berechnet werden.

Im Unterschied zur ersten Ausführungsform weist das Stromversorgungssystem 2 gemäß der dritten Ausführungsform ferner nicht nur Verbraucher 6, sondern auch eine Energiequelle 14 in Form einer Photovoltaikanlage und einen Energiespeicher 15 in Form eine Batterie auf. Die aktuellen Einspeise- und Ladezustandsdaten der Energiequelle bzw. des Energiespeichers werden über separate Datenleitungen 16 an die Auswerte- und Steuerungseinheit 13 übergeben. Darüber hinaus erhält die Auswerte- und Steuerungseinheit 13 die von der Erfassungseinheit 7 erfassten Energieverbrauchsdaten nebst zugehörigen Zeitprofilen der Verbraucher 6 über eine weitere separaten Datenleitung 17. Ferner ist die Auswerte- und Steuerungseinheit 13 über Steuerleitungen 19 mit den Verbrauchern 6 verbunden, so dass eine aktive Steuerung der Einschaltzeiten der Verbraucher 6 durch die Auswerte- und Steuerungseinheit 13 ermöglicht wird.

In der Auswerte- und Steuerungseinheit 13 liegen nun sämtliche Informationen über den aktuellen und den zu erwartenden Energiebedarf der Verbraucher 6, sowie die aus lokalen Energiequellen 14 und -speichern 15 zur Verfügung stehenden Kapazitäten vor. Auf Grundlage dieser Informationen wird von der Auswerte- und Steuerungseinheit 13 ein effizientes Energiemanagement erstellt und in Abhängigkeit dieses Energiemanagements die Verbraucher 6 gesteuert. Beispielsweise ist denkbar, dass ein Verbraucher in Form eines Kühlaggregats für einen Kühlraum tagsüber mit höherer Leistung betrieben wird, da tagsüber zusätzliche Energie aus der Photovoltaikanlage zur Verfügung steht und häufig die Türe zum Kühlraum geöffnet werden muss, und das Kühlaggregat nachts mit niedriger Leistung betrieben wird, da nachts die Türe in der Regel geschlossen bleibt und lediglich zusätzliche Energie aus dem Energiespeicher zur Verfügung steht. Eine solche intelligente Steuerungsmöglichkeit eines Verbrauchers 6 wird von der Auswerte- und Steuerungseinheit 13 automatisch anhand des zugehörigen Zeitprofils erkannt und realisiert.

Die Auswerte- und Steuerungseinheit 13 weist ferner vorzugsweise eine Webschnittstelle 18 auf, welche eine Fernwartung oder Fernsteuerung der Auswerte- und Steuerungseinheit 13 erlaubt.

### Bezugszeichenliste

- 1: Vorrichtung
- 2: Stromversorgungssystem
- 3: Zentralleitung
- 4: Privathaushalt
- 5: Subleitung
- 6: Verbraucher
- 7: Erfassungseinheit
- 8: Analog-Digital-Wandler
- 9: Verteilerkasten
- 10: Eingangskanal
- 11: Messwandler
- 12: Signalleitungen
- 13: Auswerte- und Steuerungseinheit
- 14: Energiequelle
- 15: Energiespeicher
- 16: Datenleitung
- 17: Datenleitung
- 18: Webschnittstelle
- 19: Steuerleitung
- 20: Multiplexer

## Patentansprüche

1. Vorrichtung (1) zur Erfassung eines Energieverbrauchs in einem lokalen Stromversorgungssystem (2), welches wenigstens eine Zentralleitung (3) und mehrere von der Zentralleitung (3) abzweigende und mit Verbrauchern (6) verbundene Subleitungen (5) aufweist, wobei die Vorrichtung (1) wenigstens eine Erfassungseinheit (7) zur zentralen Erfassung der individuellen Energieverbräuche der einzelnen Verbraucher (6) aufweist, wobei die Erfassungseinheit (7) wenigstens einen Analog-Digital-Wandler (8) zur Erfassung der elektrischen Spannung auf der Zentralleitung (3) aufweist, wobei wenigstens ein analoger Eingang des Analog-Digital-Wandlers (8) mit der Zentralleitung (3) verbunden ist, wobei die Erfassungseinheit (7) eine Mehrzahl von Eingangskanälen (10) aufweist, wobei jeder Eingangskanal (10) mit einem in eine der Subleitungen (5) eingebundenen Messwandler (11) zur Messung des Stromflusses durch diese Subleitung (5) gekoppelt ist, wobei die Erfassungseinheit (7) zum sukzessiven Abtasten der Eingangskanäle (10) und zur Bestimmung der individuellen Energieverbräuche in jeder Subleitung (5) in Abhängigkeit des gemessenen Stromflusses durch diese Subleitung (5) und der analog-digital-gewandelten Spannung auf der Zentralleitung (3) konfiguriert ist.

2. Vorrichtung (1) nach Anspruch 1, wobei die Vorrichtung (1) einen Multiplexer aufweist, welcher beim sukzessiven Abtasten der Eingangskanäle (10) die Eingangskanäle (10) nacheinander auf den analogen Eingang des Analog-Digital-Wandlers (8) oder auf einen analogen Eingang eines weiteren Analog-Digital-Wandlers (8) schaltet.

3. Vorrichtung (1) nach einem der vorhergehenden Ansprüche, wobei die Messwandler (11) jeweils einen Stromwandler, insbesondere in Form einer Durchsteckspule, durch welche jeweils die zugehörige Subleitung verläuft, umfassen.

4. Vorrichtung (1) nach Anspruch 2, wobei die Vorrichtung (1) für jeden Messwandler (11) einen Messwiderstand aufweist, wobei je ein Messwiderstand mit einem Eingangskanal (10) gekoppelt ist.

5. Vorrichtung (1) nach einem der vorhergehenden Ansprüche, wobei die Messwandler (11) jeweils über separate Signalleitungen (12) mit den Messwiderständen fest verdrahtet und indirekt insbesondere mit den Eingangskanälen (10) fest gekoppelt sind.

6. Vorrichtung (1) nach einem der vorhergehenden Ansprüche, wobei die Messwandler (11) jeweils über eine drahtlose Funkverbindung mit den Eingangskanälen (10) zumindest indirekt gekoppelt sind.

7. Vorrichtung (1) nach einem der vorhergehenden Ansprüche, wobei die Messwandler (11) über die jeweilige Subleitung (5) mit den Eingangskanälen (10) indirekt gekoppelt sind, wobei die Vorrichtung (1), insbesondere der Messwandler (11), einen Modulator zum Modulieren der gemessenen Messdaten auf die Subleitung (5) aufweist und wobei die Vorrichtung (7) eine Demodulator zum Demodulieren der auf die Subleitung (5) modulierten Messdaten aufweist.

8. Vorrichtung (1) nach einem der vorhergehenden Ansprüche, wobei die Zentralleitung (3) einen ersten, zweiten und dritten Außenleiter aufweist, wobei der erste, zweite und dritten Außenleiter nacheinander auf den analogen Eingang des Analog-Digital-Wandlers (8) schaltbar sind.

9. Vorrichtung (1) nach einem der vorhergehenden Ansprüche, wobei die Erfassungseinheit (7) derart konfiguriert ist, dass in Abhängigkeit der auf der Zentralleitung erfassten zeitabhängigen elektrischen Spannung und des in der jeweiligen Subleitung erfassten zeitabhängigen elektrischen Stroms für jede Subleitung die Phasenbeziehung zwischen Spannung und Strom bestimmt und daraus die in der betreffenden Subleitung anfallende Wirkleistung ermittelt wird.

10. Vorrichtung (1) nach einem der vorhergehenden Ansprüche, wobei die Erfassungseinheit (7) einem Mikrocontroller, einen Mikroprozessor und/oder einen programmierbaren logischen Schaltkreis (FPGA) umfasst, wobei optional der Analog-Digital-Wandler (8) und/oder der weitere Analog-Digital-Wandler (8) in den Mikrocontroller, den Mikroprozessor und/oder den programmierbaren logischen Schaltkreis integriert ist.

11. Vorrichtung (1) nach einem der vorhergehenden Ansprüche, wobei die Erfassungseinheit (7) im Bereich einer Niederspannungsunterverteilung eines Gebäudes, eines Hausanschlusskastens, eines zentralen Verteilerkastens (9) oder einer Zähleranschlusssäule angeordnet ist.

12. Verfahren zur Erfassung eines Energieverbrauchs in einem lokalen Stromversorgungssystem (2), welches wenigstens eine Zentralleitung (3) und mehrere von der Zentralleitung (3) abzweigende und mit Verbrauchern (6) verbundene Subleitungen (5) aufweist, insbesondere mittels einer Vorrichtung (1) gemäß einem der vorhergehenden Ansprüche, mit den Verfahrensschritten:
- Erfassen der elektrischen Spannung auf der Zentralleitung (3);
- Wandeln des erfassten Spannungswertes in einen digitalen Spannungswert mittels wenigstens einen Analog-Digital-Wandlers (8);
- Erfassen von durch Subleitungen (5) zu den Verbrauchern (6) fließenden Stromflüssen mittels in die Subleitungen (5) jeweils eingebundene Messwandler (11),
- Übergeben des erfassten Strommesswertes an separate Eingangskanäle (10) einer Erfassungseinheit (7);
- Sukzessives Abtasten der Eingangskanäle (10) der Erfassungseinheit (7);
- Bestimmen der individuellen Energieverbräuche in jeder Subleitung (5) in Abhängigkeit des abgetasteten Strommesswertes für diese Subleitung (5) und der analog-digital-gewandelten Spannung auf der Zentralleitung (3).

13. Verfahren nach Anspruch 12, wobei mittels einer Auswerteeinheit (13) Zeitprofile der Energieverbräuche der einzelnen Verbraucher (6) erstellt werden.

14. Verfahren nach einem der Ansprüche 12 oder 13, wobei die an den Eingangskanälen (10) anliegenden Strommesswerte und optional des Spannungswertes wenigstens eines Außenleiters der Zentralleitung mittels eines Multiplexer sukzessive auf einen analogen Eingang des Analog-Digital-Wandlers (8) geschaltet werden.

15. Verfahren nach einem der Ansprüche 12 bis 14, wobei der durch die jeweiligen Subleitungen fließende Strom mittels Messwandlern (11) in Form von Stromwandlern und insbesondere Durchsteckspulen erfasst und mittels Messwiderständen in Strommesswerte umgewandelt werden und/oder wobei die von den Messwandlern (11) gemessenen Strommessmesswerte auf die Subleitung (5) moduliert werden und von der Vorrichtung (1) demoduliert und auf die Eingangskanälen (10) gelegt werden.
